# FASCICULE DE BREVET EUROPEEN

(11) **EP 1 050 844 B1**
(45) Date de publication et mention de la délivrance du brevet: **10.07.2013**
(21) Numéro de dépôt: 00401127.6
(22) Date de dépôt: 21.04.2000
(51) Int. Cl.: G06K 19/077

(54) **Procédé de fabrication d'une carte à microcircuit**
Verfahren zum Herstellen einer Chipkarte
Method of manufacturing a chip card

(30) Priorité: 06.05.1999 FR 9905779
(43) Date de publication de la demande: 08.11.2000
(73) Titulaire: Oberthur Technologies, 92700 Colombes (FR)
(72) Inventeur: Bouchez, François, 14790 Verson (FR); Bouvard, Jérôme, 14150 Ouistreham (FR); Launay, François, 4610 Epron (FR); Loubly, Pierre, 14000 Caen (FR)
(74) Mandataire: Santarelli

(56) Documents cités:
- EP-A- 0 472 766
- FR-A- 2 670 930
- US-A- 5 304 513

## Description

L'invention se rapporte à un procédé de fabrication d'une carte à microcircuit comprenant notamment une étape d'enrobage du microcircuit dans un matériau d'enrobage durcissable, typiquement une résine. Elle concerne plus particulièrement un perfectionnement permettant de mieux contrôler l'étalement du matériau d'enrobage avant durcissement. Avantageusement, le procédé permet aussi d'améliorer l'adhérence d'une résine ou colle mise en oeuvre au cours de la fabrication d'une telle carte à microcircuit.

Il est connu d'adapter l'état de surface d'un élément pour favoriser l'adhérence d'une colle sur celui-ci. Par exemple, on sait que l'énergie de surface (que l'on peut exprimer en Joule/m2) d'une colle ou résine peut être adaptée à celle de la surface sur laquelle on dépose cette colle ou résine, pour obtenir une bonne adhérence conditionnée par un mouillage convenable du support par la résine ou colle concernée.

D'une façon générale, on sait que le mouillage est augmenté si on augmente la rugosité de la surface. Notamment, il est connu de traiter une surface à l'aide d'un faisceau laser pour adapter son état de surface. En revanche, un trop bon mouillage peut entraîner un étalement excessif de la colle ou résine, au-delà de limites souhaitées.

L'invention a généralement pour but de mettre à profit les techniques de traitement de surface et tout particulièrement le traitement de surface -par faisceau laser pour mieux contrôler l'étalement d'une colle ou résine à une étape donnée de la fabrication d'une carte à microcircuit, dans le but de mieux maîtriser l'étalement et/ou l'adhérence d'un matériau durcissable, éventuellement réactivable à chaud.

D'une façon générale, l'invention concerne un procédé de fabrication d'une carte à microcircuit comportant une étape d'enrobage dudit microcircuit dans un matériau d'enrobage durcissable, caractérisé par les opérations consistant à traiter la surface (B, C) d'un support entrant dans la constitution d'une telle carte en y définissant au moins de première et seconde zones d'états de surface différents (B, E) dont la première zone (B) a une rugosité supérieure à celle de la seconde zone (E) qui lui est extérieurement adjacente en s'étendant toutes deux au-delà d'un emplacement prédéterminé (21) dudit microcircuit et sensiblement concentriquement par rapport à cet emplacement et à déposer ultérieurement ledit matériau (26) précité sur une plage centrée par rapport audit emplacement, ledit matériau englobant ledit microcircuit, en sorte que l'étalement dudit matériau, dont la tension superficielle est comprise entre celles des deux zones d'état de surface différents et qui est destiné à recouvrir la zone de rugosité supérieure, soit dépendant des formes, dimensions et états de surface de ces zones.

On connaissait déjà d'après le document EP 0 472 766 une configuration dans laquelle une puce semiconductrice était montée sur une bande de support munie d'une structure de pistes conductrices et enrobée par une masse dont l'écoulement était arrêté par un sillon formé à la surface de cette bande de support.

Par exemple. l'une des zones résulte alors du traitement de surface, tandis que l'autre peut être une surface non traitée présentant la rugosité d'origine, généralement plus faible, du support lui-même. De préférence, le traitement précité met en oeuvre l'action d'un faisceau laser. On peut par exemple avoir recours à un générateur de faisceau laser UV qui, grâce à une forte énergie photonique permet de rompre en surface les liaisons covalentes du matériau polymère sans échauffer cette surface de façon significative. On évite ainsi de déformer le matériau polymère constituant le support. En revanche, un laser de type YAG pourra être utilisé pour réaliser sur le support une trame de microcavités voire de microsillons se traduisant par une augmentation macroscopique de la rugosité qui s'ajoute à l'effet de modification de l'énergie de surface du matériau dû à l'ablation des couches superficielles.

Ce traitement peut permettre, par exemple, de ne pas utiliser d'adhésif pour certaines opérations, notamment la fixation d'un module à l'emplacement prévu sur le corps de carte. On peut obtenir un ancrage mécanique direct du support en matière plastique (la carte) dans lesdites microcavités, par fluage de la matière plastique de la carte dans les microcavités de la zone traitée, sous l'effet de l'application d'un outil chauffant.

L'invention sera mieux comprise et d'autres avantages de celle-ci apparaîtront plus clairement à la lumière de la description qui va suivre de plusieurs exemples de mise en oeuvre du procédé conforme à son principe, donnée uniquement à titre d'exemple et faite en référence aux dessins annexés dans lesquels :
- les figures 1 à 6 illustrent schématiquement la fabrication d'une plaquette de connexion à microcircuit entrant dans le processus de fabrication d'une carte à microcircuit et mettant en oeuvre un traitement de surface conforme à l'invention ;
- les figures 7 à 11 illustrent plus particulièrement une autre partie d'un procédé de fabrication d'une carte à microcircuit, comprenant plus particulièrement les opérations de traitement du corps de carte et notamment un traitement de surface d'une cavité, mettant en oeuvre le principe de l'invention ;
- les figures 12a et 12b illustrent deux possibilités pour effectuer un dépôt de colle ou résine, pendant la mise en oeuvre du procédé ; et
- la figure 13 illustre une autre variante appliquée à la fixation de la plaquette.

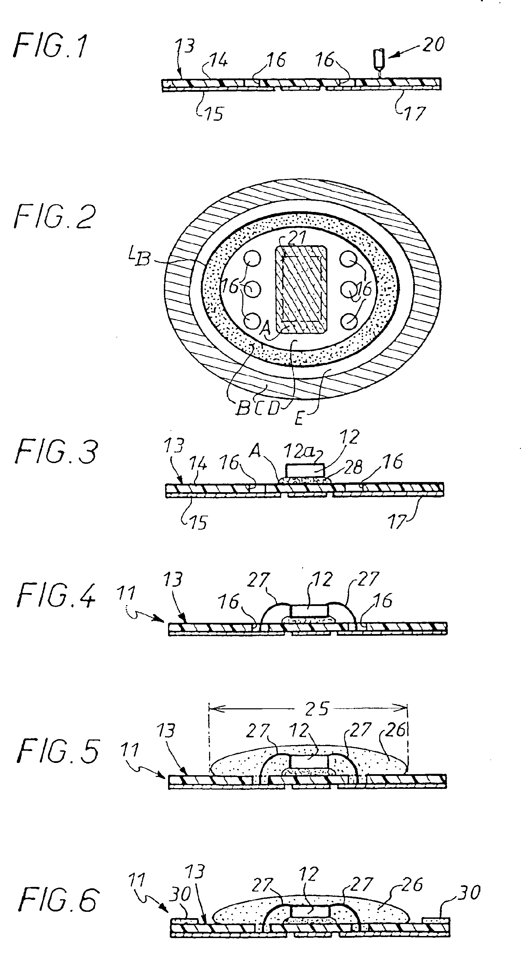

En se reportant plus particulièrement aux figures 1 à 6, on va décrire en détail les opérations de fabrication d'un module 11 portant le microcircuit 12 et apte à être monté ultérieurement sur un autre support, en l'occurrence dans la cavité ménagée à cet effet d'un corps de carte en matière plastique. Le module se compose quant à lui d'une plaquette de connexion 13 généralement réalisée dans un film souple et comportant une couche isolante 14 et une couche métallique 15 accolées l'une à l'autre. Des trous ou puits de connexion 16 sont pratiqués dans la partie isolante tandis que la partie métallique est découpée pour définir des plages de connexion 17. De façon classique, le microcircuit 12 est destiné à être fixé au centre de la plaquette de connexion 13, sur la surface isolante et des fils, généralement en or, sont soudés entre sa face de connexion 12a et les plages de raccordement 17, au travers desdits puits de connexion 16. Les films métallisés dans lesquels sont découpées les plaquettes de connexion sont généralement en polyimide, en polyester ou en verre-époxy. Lorsque les plages de connexion, du côté métallisé et les puits de connexion, du côté isolant, ont été définis par des opérations classiques qui ne seront pas décrites ici en détails et qui ne font pas partie de l'invention, on dispose d'une plaquette de connexion conforme à la figure 1. C'est à ce stade que le principe de l'invention peut être avantageusement appliqué. Il s'agit d'un traitement de surface localisé à des zones prédéterminées de la couche isolante de la plaquette de connexion.

Dans l'exemple, ce traitement de surface est opéré à l'aide d'un faisceau laser 20. Pour la mise en oeuvre de l'invention, le traitement par faisceau laser est considéré, à ce jour, comme préférentiel.

Selon la définition qui précède, la mise en oeuvre de l'invention appliquée à cette plaquette de connexion consiste à traiter la surface de ladite plaquette en y définissant au moins deux zones d'états de surfaces différents s'étendant au-delà d'un emplacement prédéterminé 21 dudit microcircuit et sensiblement concentriquement par rapport à cet emplacement. La figure 2 montre un exemple de zone traitée. Dans cet exemple, on a traité trois zones A, B et C. Ces zones ne sont pas forcément homothétiques les unes des autres mais elles sont sensiblement centrées par rapport à l'emplacement du microcircuit. Par exemple, la zone A, la plus centrale, a à peu près la même forme que le microcircuit, mais sa surface est plus importante que la surface de base du microcircuit. Cependant, cette zone traitée n'atteint pas les puits de connexion 16, comme cela est visible sur la figure 2 et les limites extérieures de celle-ci sont même nettement distantes desdits puits de connexion. Le traitement de la zone A est avantageux mais n'est pas indispensable.

En revanche, le traitement de la zone annulaire B est considéré comme très avantageux. Cette zone est définie à l'intérieur d'une zone de confinement souhaitée 25 du matériau d'enrobage 26 qui est destiné à venir recouvrir le microcircuit 12 (figure 5).

En d'autres termes, la ligne L_{B} représente la limite souhaitée de la goutte de matériau d'enrobage qui sera ultérieurement déposée sur le microcircuit 12 lui-même collé au centre de la plaquette. Cette limite est déterminée pour garantir un bon enrobage du microcircuit, sans manque, mais le matériau d'enrobage (résine) ne doit pas s'étendre au-delà, pour ne pas constituer un obstacle à une opération ultérieure consistant à fixer le module dans la cavité préparée dans le corps de carte.

Selon une caractéristique remarquable de l'invention, on traite donc la plaquette sur la zone B s'étendant à l'intérieur de la limite de confinement souhaitée L_{B} et au moins au voisinage de celle-ci (la zone traitée a donc ici une forme annulaire et ne se confond pas ou ne rejoint pas la zone A).

Enfin, on traite en outre une zone annulaire C de la plaquette, distincte de la zone B à l'extérieur de celle-ci et au voisinage du bord de la plaquette, ce traitement de surface permettra, comme on le verra plus loin, de favoriser une opération ultérieure de fixation de la plaquette dans la cavité d'un autre support plan formant corps de carte.

Entre les zones traitées mentionnées ci-dessus, on distingue deux zones non traitées. La zone D s'étend entre la zone A et la zone B et les puits de connexion se situent dans cette zone. La zone E est une zone annulaire non traitée se situant entre la zone B (c'est-à-dire au-delà de la limite de confinement souhaitée) et le bord intérieur de la zone C. La zone C étant facultative, la zone non traitée E peut parfaitement s'étendre jusqu'au bord de la plaquette de connexion. Les traitements de surface des zones A, B et C peuvent être effectués à l'aide d'un même faisceau laser mais ces traitements sont généralement différenciés (en intensité, vitesse de balayage, etc...) en fonction des matériaux durcissables, colle et/ou résine, qui doivent être déposés ultérieurement. Quoi qu'il en soit, la rugosité d'une zone traitée A, B ou C sera généralement supérieure à la rugosité d'une zone non traitée D ou E et c'est précisément la transition entre une zone traitée et une zone non traitée, par exemple au voisinage de la limite de confinement souhaitée L₈, qui joue un rôle important dans le comportement du matériau durcissable au moment où il est mis en oeuvre. Une zone traitée, c'est-à-dire une zone de rugosité augmentée s'avère favorable à un bon mouillage de la surface par le matériau durcissable (colle ou résine) l'énergie de surface de la zone traitée étant supérieure à l'énergie de surface du matériau. Ainsi, le fait d'avoir traité la zone A permet un meilleur collage du microcircuit (figure 3) mais, lorsque le matériau 28 (la colle) arrive aux limites de la zone A, sa progression vers l'extérieur est plus difficile, de sorte qu'il ne s'étale au-delà des limites de la zone A, comme représenté sur la figure 3.

Par conséquent, au moment du collage du microcircuit 12 au centre de la plaquette, les puits de connexion 16 sont épargnés par la colle.

L'opération illustrée à la figure 4, à savoir le raccordement électrique du microcircuit par des fils 27 entre ses plages de connexion et les plages de raccordement 17 s'en trouve donc facilitée et fiabilisée. En outre, le collage du microcircuit est de meilleure qualité.

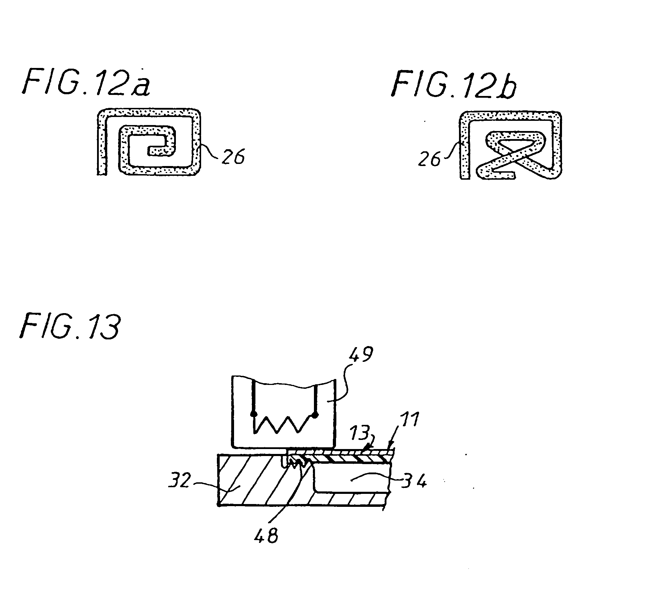

L'opération suivante, illustrée à la figure 5, consiste à enrober le microcircuit 12 et ses fils de connexion 27 dans une goutte de matériau d'enrobage appelé à recouvrir l'ensemble des zones A et B incluant le microcircuit, sans s'étendre au-delà de la limite L_{B}. Le matériau d'enrobage 26 est déposé par des buses (non représentées) sur toute la partie centrale de la plaquette de connexion. Les buses sont de préférence déplacées selon un trajet prédéterminé, par exemple conforme à celui qui est représenté sur la figure 12a ou 12b. Le déplacement des buses assure une meilleure répartition du matériau d'enrobage sur la surface considérée. Lorsque le matériau se propage sur la zone B, la rugosité de cette zone est favorable à un écoulement naturel du matériau vers l'extérieur. Cependant, lorsque la limite L_{B} est atteinte, la progression du matériau est stoppée du fait qu'il rencontre une zone E d'énergie de surface beaucoup plus faible. De préférence, on choisira un matériau d'enrobage dont l'énergie de surface est comprise entre celle de la zone traitée (zone B) et celle de la zone adjacente extérieure non traitée (zone E). Le résultat est celui illustré à la figure 5 où l'on voit que le matériau d'enrobage a été contenu à l'intérieur de la limite L_{B} souhaitée. Ce confinement permet d'être sûr que le module ainsi constitué pourra prendre place dans la cavité du corps de carte, sans difficulté ou intervention supplémentaire.

Sur la figure 6, on a représenté une opération supplémentaire, facultative, qui consiste à déposer un anneau de colle 30, par exemple une colle réactivable à chaud sur la zone annulaire C, si elle existe. En choisissant convenablement l'énergie de surface donnée à la zone C par le traitement au faisceau laser, compte tenu de la nature de la colle utilisée, on peut là encore améliorer l'adhérence et/ou mieux maîtriser les limites du dépôt de cette colle.

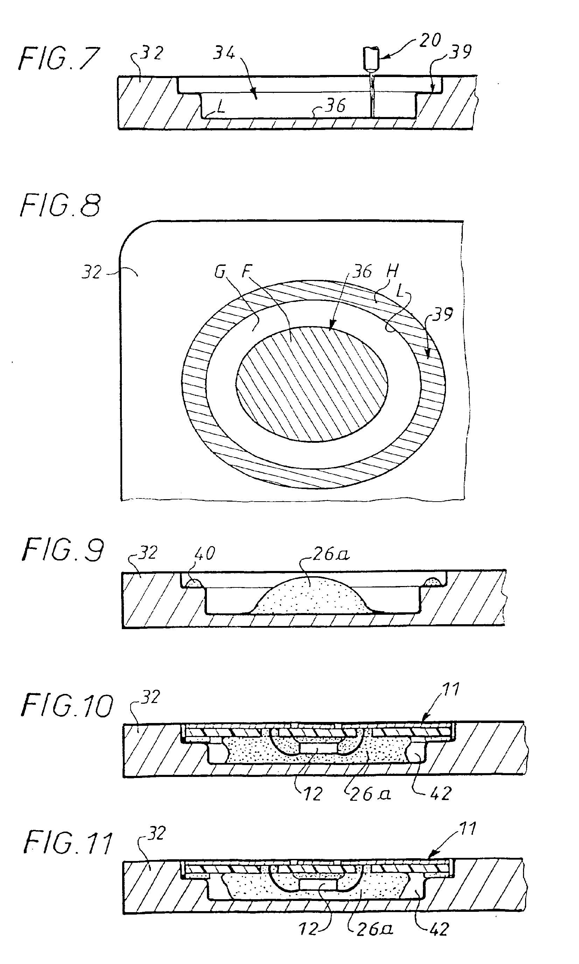

Les figures 7 à 10 illustrent la mise en oeuvre du principe de l'invention appliquée cette fois au traitement de certaines parties de surface du corps de carte 32 en matière plastique dans lequel on a pratiqué une cavité 34 destinée à accueillir un module 11. Dans le cas présent, le module se trouve dans l'état illustré à la figure 4, c'est-à-dire qu'il n'a pas subi la phase d'enrobage de la figure 5.

Dans l'exemple, la cavité 34 comporte un fond plat 36 de limite L. Du côté de l'ouverture, la cavité s'élargit pour former une margelle 39. La profondeur de cette margelle correspond à l'épaisseur de la plaquette de connexion et (éventuellement) de la couche de colle prévue pour fixer cette plaquette de connexion. Lorsque le module est en place, le microcircuit 12 s'étend dans la partie la plus profonde de la cavité 34.

Si le module a subi une phase d'enrobage, comme à la figure 5, il est retourné dans la cavité et fixé uniquement sur la margelle de celle-ci. On connaît cependant une variante dans laquelle le matériau d'enrobage est déposé dans la cavité ; sur le fond plat 36. Cette technique d'enrobage est décrite par exemple dans le document de brevet européen N° 0 414 314 appartenant à la Demanderesse.

Le principe inventif de l'invention peut donc être mis en oeuvre lors de l'élaboration du corps de carte et plus particulièrement au moment où on prépare la cavité. Dans ce cas, un traitement de surface est mis en oeuvre pour définir une zone traitée F sensiblement centrée par rapport au fond 36 de la cavité. Cependant, le traitement n'est opéré que dans une zone centrale et non pas sur la totalité du fond de la cavité. On laisse donc subsister une zone non traitée G entre la zone centrale traitée F et le périmètre du fond L, plus particulièrement celui du fond de la cavité non compris la margelle.

En même temps, on peut, si cela est avantageux, effectuer un autre traitement de surface H sur la margelle en vue de faciliter ultérieurement la fixation du module. Cette opération qui consiste à traiter au moins une zone annulaire sur la margelle n'est pas indispensable, elle dépend du type de collage retenu pour la fixation du module. Après traitement au faisceau laser, on obtient donc une configuration conforme à la figure 8.

L'opération de la figure 9 consiste à déposer un matériau d'enrobage 26a durcissable sur une zone centrée de la cavité, c'est-à-dire dans la zone F. Le module 11 conforme à la figure 4 est ensuite placé dans la cavité 34 dans une position telle que le microcircuit s'englobe dans le matériau durcissable, comme représenté sur la figure 10. Si une colle 40 a été déposée sur la margelle, la même opération se traduit par la fixation du module. Si on a utilisé une colle thermoactivable, la fixation définitive du module peut intervenir ultérieurement sous l'effet d'un outil chauffant.

En considérant la figure 10, on remarque que, comme dans l'exemple précédent, le matériau d'enrobage 26a s'est maintenu naturellement à l'intérieur de la zone traitée F du fond de la cavité, son étalement vers l'extérieur dudit fond étant arrêté à la transition de la zone traitée F et de la zone non traitée G dudit fond, s'étendant jusqu'à la périphérie L de celui-ci.

Comme précédemment, la tension superficielle du matériau d'enrobage est de préférence choisie pour être comprise entre celle de la zone traitée centrale et celle de la zone adjacente extérieure, non traitée, du fond. Du fait que le matériau durcissable n'atteint pas le contour du fond de la cavité, il se forme un anneau d'air 42 dans la cavité, tout autour du microcircuit. L'intérêt d'un tel anneau d'air (qui peut être obtenu en tout état de cause moins facilement, sans traitement de la zone centrale) est décrit dans une autre demande de brevet déposée conjointement par la Demanderesse.

On rappelle brièvement que le fait de dégager la périphérie du fond de la cavité, c'est-à-dire d'éviter que le matériau 26a y parvienne, permet de réduire très sensiblement les contraintes de flexion au voisinage du fond de la cavité.

Si le module qui est intégré dans la cavité a été prévu avec une zone traitée B conforme à la représentation de la figure 2, alors, la formation de l'anneau s'en trouve encore améliorée et facilitée, le matériau d'enrobage prenant la forme illustrée à la figure 11.

Enfin, le traitement de surface macroscopique peut être mis en oeuvre, comme le montre la figure 13, pour créer par exemple une trame de microcavités 48 dans la zone de fixation de la plaquette de connexion 13, correspondant à la margelle de la cavité. Si ces microcavités sont suffisamment profondes, dans la pratique quelques dizaines de microns, on peut obtenir un ancrage mécanique direct entre le corps de carte 32 et la plaquette de connexion du module, à l'aide d'un outil chauffant 49, en faisant fluer la matière plastique du corps de carte, dans les microcavités ou microsillons de la plaquette. On s'affranchit ainsi de l'utilisation de tout adhésif pour fixer le module dans la cavité du corps de carte. On a expérimenté avec succès, à cet effet, un laser YAG d'une longueur d'ondes de 1064 nanomètres et d'une puissance nominale de 65 watts avec une tête galvanométrique configurée avec une lentille de diamètre 160 mm. De bons résultats ont été obtenus sur différents supports en matière plastique tels que le PBT (polybutylène téréphtalate) ou encore sur des matériaux plus classiques tels que le PVC (polychlorure de vinyle), le PET (polyéthylène téréphtalate), ou encore le polycarbonate ou l'ABS (acrylonitrile butadiène styrène). Les meilleurs résultats ont été obtenus avec des microcavités de 80 à 100 microns de diamètre, d'une profondeur de 20 microns, avec une largeur de trame de 300 microns.

## Revendications

1. Procédé de fabrication d'une carte à microcircuit comportant une étape d'enrobage dudit microcircuit dans un matériau d'enrobage durcissable, **caractérisé par** les opérations consistant à traiter la surface (B, C) d'un support entrant dans la constitution d'une telle carte en y définissant au moins de première et seconde zones d'états de surface différents (B, E) dont la première zone (B) a une rugosité supérieure à celle de la seconde zone (E) qui lui est extérieurement adjacente en s'étendant toutes deux au-delà d'un emplacement prédéterminé (21) dudit microcircuit et sensiblement concentriquement par rapport à cet emplacement et à déposer ultérieurement ledit matériau (26) précité sur une plage centrée par rapport audit emplacement, ledit matériau englobant ledit microcircuit, en sorte que l'étalement dudit matériau, dont la tension superficielle est comprise entre celles des deux zones d'état de surface différents et qui est destiné à recouvrir la zone de rugosité supérieure, soit dépendant des formes, dimensions et états de surface de ces zones.

2. Procédé selon la revendication 1, **caractérisé en ce que** la seconde zone (E) extérieurement adjacente à la première zone (B) de rugosité supérieure est non traitée.

3. Procédé selon la revendication 1 ou la revendication 2, **caractérisé en ce que** le traitement précité met en oeuvre l'action d'un faisceau laser (20).

4. Procédé selon la revendication 3, **caractérisé en ce que** le traitement précité met en oeuvre l'action d'un faisceau laser UV.

5. Procédé selon l'une des revendications précédentes, **caractérisé en ce qu'**on applique le traitement précité à la surface d'une plaquette de connexion (13), par exemple issue d'un film souple et **en ce qu'**on vient fixer ledit microcircuit (12) sur cette plaquette pour constituer un module apte à être monté sur un autre support.

6. Procédé selon la revendication 5, **caractérisé en ce que**, pour une limite de confinement souhaitée (L_{B}) dudit matériau, tout autour dudit emplacement prédéterminé (21), on traite ladite plaquette (13) sur une zone formant la première zone (B) s'étendant à l'intérieur de cette limite de confinement et au moins au voisinage de celle-ci en sorte d'obtenir une diminution notable d'énergie de surface, à la transition entre la zone traitée (B) et la zone adjacente extérieure (3) non traitée formant la seconde zone (E).

7. Procédé selon la revendication 6, **caractérisé en ce qu'**on traite en outre une zone annulaire (C) ladite plaquette, distincte de ladite première zone et à l'extérieur de celle-ci, en sorte de favoriser une opération ultérieure de fixation de ladite plaquette dans une cavité d'un autre support plan.

8. Procédé selon l'une des revendications 6 ou 7, **caractérisé en ce qu'**on traite une zone centrale (A) de ladite plaquette, distincte de ladite première zone traitée au voisinage de la limite de confinement et séparée de celle-ci par des points (16) de connexion des fils dudit microcircuit, en vue de favoriser une opération ultérieure de collage dudit microcircuit sur ladite plaquette, lesdits trous de connexion étant distincts et situés à distance des limites de cette zone centrale traitée.

9. Procédé selon l'une des revendications précédentes, **caractérise en ce qu'**on applique un traitement précité dans une zone centrale (F) du fond d'un cavité (34) pratiquée dans un autre support plan formant corps de carte, **en ce qu'**on dépose le matériau, durcissable, (26a) sur cette zone centrale, **en ce qu'**on réalise par ailleurs, de façon connue en soi, un module (11) comprenant une plaquette de connexion et un microcircuit monté sur cette plaquette et **en ce qu'**on place ledit module dans ladite cavité, dans une position telle que ledit microcircuit (12) s'englobe dans ledit matériau durcissable (26a).

10. Procédé selon la revendication 9, **caractérisé en ce que** ladite zone centrale de la cavité s'inscrit à distance du contour (L) du fond de la cavité, en sorte que ledit matériau durcissable n'atteigne pas ledit contour du fond de la cavité et laisse subsister un anneau d'air (42) dans la cavité tout autour dudit microcircuit.

11. Procédé selon la revendication 9, selon lequel on définit une telle cavité comportant en outre une margelle (39) dont la hauteur correspond à l'épaisseur de ladite plaquette, **caractérisé en ce qu'**on traite cette margelle périphérique en sorte de favoriser une opération ultérieure de collage de ladite plaquette sur cette zone margelle périphérique.

12. Procédé selon la revendication 7, **caractérisé en ce que** l'opération de fixation de ladite plaquette est une opération de chauffage d'un adhésif thermo-activable déposé sur ladite zone annulaire.

13. Procédé selon la revendication 7, **caractérisé en ce que** le traitement de ladite zone annulaire comporte la formation de microcavités ou microsillons (48) dans celle-ci et **en ce que** l'opération de fixation de ladite plaquette consiste à chauffer ladite zone annulaire en place sur l'autre support plan précité, jusqu'à faire fluer la matière qui le constitue dans lesdites microcavités ou microsillons.

## Patentansprüche

1. Verfahren zum Herstellen einer Chipkarte, umfassend einen Schritt der Umhüllung des Chips mit einem härtbaren Umhüllungsmaterial, **gekennzeichnet durch** Verfahren bestehend aus der Behandlung der Oberfläche (B, C) einer Verstärkung, die in den Aufbau einer solchen Karte hineinragt, wobei sie mindestens einen ersten und einen zweiten Bereich mit unterschiedlichen Oberflächenbeschaffenheiten (B, E) bestimmt, wobei der erste Bereich (B) eine größere Rauheit aufweist als der zweite Bereich (E), der äußerlich an den ersten Bereich angrenzt, indem sich beide Bereiche über eine vorbestimmte Stelle (21) des Chips erstrecken und in etwa konzentrisch zu der Stelle angeordnet sind, und bestehend aus dem späteren Aufbringen des oben genannten Materials (26) auf eine Fläche, die im Hinblick auf die Stelle zentriert angeordnet ist, wobei das Material den Chip umhüllt, derart, dass die Verteilung des Materials, dessen Oberflächenspannung zwischen den Oberflächenspannungen der zwei Bereiche mit unterschiedlichen Oberflächenbeschaffenheiten liegt, und das dazu bestimmt ist, den Bereich mit der größeren Rauheit zu umhüllen, von der Form, den Abmessungen und der Beschaffenheit der Oberflächen dieser Bereiche anhängig ist.

2. Verfahren nach Anspruch 1, **dadurch gekennzeichnet, dass** der zweite Bereich (E), der äußerlich an den ersten Bereich (B) mit der größeren Rauheit angrenzt, nicht behandelt wird.

3. Verfahren nach Anspruch 1 oder Anspruch 2, **dadurch gekennzeichnet, dass** die oben genannte Behandlung den Betrieb eines Laserstrahls (20) auslöst.

4. Verfahren nach Anspruch 3, **dadurch gekennzeichnet, dass** die oben genannte Behandlung den Betrieb eines UV-Laserstrahls auslöst.

5. Verfahren nach einem der vorhergehenden Ansprüche, **dadurch gekennzeichnet, dass** die oben genannte Behandlung an der Oberfläche einer Anschlussplatte (13) erfolgt, beispielsweise durch Auftragen einer flexiblen Schicht, und dass der Chip (12) auf der Platte angebracht wird, um ein Modul zu bilden, das sich auf eine andere Unterlage montieren lässt.

6. Verfahren nach Anspruch 5, **dadurch gekennzeichnet, dass**, innerhalb eines gewünschten Eingrenzungsbereiches (LB) des Materials, die Platte (13) in einem Bereich, der den ersten Bereich bildet (B) und der sich innerhalb dieses Eingrenzungsbereiches und mindestens in der Nähe dieses Eingrenzungsbereiches befindet, um die vorbestimmte Stelle (21) herum behandelt wird, um eine deutliche Reduktion der Oberflächenenergie im Übergangsbereich zwischen dem Bereich (B), der behandelt wird, und dem angrenzenden äußeren Bereich (3), der nicht behandelt wird und der den zweiten Bereich (E) bildet, zu erreichen.

7. Verfahren nach Anspruch 6, **dadurch gekennzeichnet, dass** überdies ein ringförmiger Bereich (C) der Platte behandelt wird, der sich von dem ersten Bereich unterscheidet und sich außerhalb davon befindet, um ein späteres Anbringen der Platte in einer Aussparung einer anderen ebenen Unterlage zu begünstigen.

8. Verfahren nach einem der Ansprüche 6 oder 7, **dadurch gekennzeichnet, dass** ein zentraler Bereich (A) der Platte behandelt wird, der sich von dem ersten behandelten Bereich in der Nähe des Eingrenzungsbereiches unterscheidet und von diesem durch Kabelverbindungspunkte (16) des Chips getrennt ist, um ein späteres Kleben des Chips auf die Platte zu begünstigen, wobei die Verbindungslöcher verschieden sind und in einem Abstand von der äußeren Grenze des zentralen Bereiches, der behandelt wird, angeordnet sind.

9. Verfahren nach einem der vorhergehenden Ansprüche, **dadurch gekennzeichnet, dass** eine oben genannte Behandlung in einem zentralen Bereich (F) des Bodens einer Aussparung (34) in einer anderen ebenen, kartenförmigen Unterlage erfolgt, indem das Material härtbar (26a) auf diesen zentralen Bereich aufgebracht wird, indem darüber hinaus in an sich bekannter Weise ein Modul (11), umfassend eine Anschlussplatte und einen auf dieser Anschlussplatte angebrachten Chip, geformt wird, und indem dieses Modul in der Aussparung in einer Position, in der der Chip (12) von dem härtbaren Material (26a) umhüllt wird, angeordnet wird.

10. Verfahren nach Anspruch 9, **dadurch gekennzeichnet, dass** der zentrale Bereich der Aussparung sich in einem Abstand von dem Umriss (L) des Bodens der Aussparung befindet, sodass das härtbare Material den Umriss des Bodens der Aussparung nicht erreicht und ein ringförmiger Abstand (42) in der Aussparung um den Chip herum bestehen bleibt.

11. Verfahren nach Anspruch 9, wobei die Aussparung dadurch bestimmt ist, dass sie überdies einen Rand (39) umfasst, dessen Größe der Dicke der Platte entspricht, **dadurch gekennzeichnet, dass** dieser umlaufende Rand behandelt wird, um ein späteres Kleben der Platte auf diesen umlaufenden Randbereich zu begünstigen.

12. Verfahren nach Anspruch 7, **dadurch gekennzeichnet, dass** das Verfahren zum Anbringen der Platte ein Verfahren der Erhitzung eines thermoaktivierbaren Klebstoffes ist, der auf den ringförmigen Bereich aufgebracht wird.

13. Verfahren nach Anspruch 7, **dadurch gekennzeichnet, dass** die Behandlung des ringförmigen Bereiches die Bildung von Mikroaussparungen oder Mikrorillen (48) in dem ringförmigen Bereich umfasst und dass das Verfahren zum Anbringen der Platte aus dem Erhitzen des ringförmigen Bereiches unmittelbar auf der oben genannten anderen Unterlage besteht, bis das Material, aus dem der ringförmige Bereich besteht, in die Mikroaussparungen oder Mikrorillen fließt.

## Claims

1. Method of fabricating a card incorporating a microcircuit, said method including a step of coating said microcircuit in a hardenable coating material, and being **characterised by** operations consisting in treating the surface (B, C) of a support incorporated in said card by defining thereon at least first and second areas which have different surface states (B, E), the first area (B) having a greater roughness than the second area (E) that is externally adjacent to it, both areas extending beyond a predetermined location (21) of said microcircuit and substantially concentrically with said location, and in subsequently depositing said material (26) in a land centred relative to said location, said material engulfing said microcircuit, so that the spreading of said material, the surface tension of which lies between those of the two areas which have different surface states, and which is intended to cover the zone of greater roughness, is dependent on the shapes, dimensions and surface states of said areas.

2. Method according to Claim 1, **characterised in that** the second area (E), externally adjacent to the first area (B) of greater roughness, is not treated.

3. Method according to Claim 1 or Claim 2, **characterised in that** said treatment employs a laser beam (20).

4. Method according to Claim 3, **characterised in that** the said treatment employs a UV laser beam.

5. Method according to one of the preceding claims, **characterised in that** said treatment is applied to the surface of a connecting board (13), for example produced from a flexible film, and **in that** said microcircuit (12) is fixed to said board to constitute a module able to be mounted on another support.

6. Method according to Claim 5, **characterised in that**, for a desired boundary (LB) limiting said material, all around said predetermined location, said board (13) is treated over an area forming the first area (B) extending into the interior of this limiting boundary and at least in the vicinity of said boundary in order to obtain a significant reduction of surface energy at the transition between the treated area (B) and the externally adjacent untreated area (3) forming the second area (E).

7. Method according to Claim 6, **characterised in that** an annular area (C) of said board separate from said first area and outside it is also treated to improve subsequent fixing of said board into a cavity in another plane support.

8. Method according to either of Claims 6 and 7, **characterised in that** a central area (A) of said board separate from said first treated area in the vicinity of the confinement boundary and separated therefrom by points (16) for connecting wires of said microcircuit is treated to improve subsequent gluing of said microcircuit to said board, said connecting holes being separate and at a distance from the boundaries of said treated central area.

9. Method according to one of the preceding claims, **characterised in that** said treatment is applied to a central area (F) of the bottom of a cavity (34) formed in another plane support forming a card body, **in that** the hardenable material (26a) is deposited over said central area, **in that** a module (11) comprising a connection board and a microcircuit mounted on said board is prepared in a manner that is known in the art, and **in that** said module is placed in said cavity in a position such that said microcircuit (12) is engulfed in said hardenable material (26a).

10. Method according to Claim 9, **characterised in that** said central cavity area is at a distance from the contour (L) of the bottom of the cavity so that said hardenable material does not reach said contour of the bottom of the cavity and leaves a ring of air (42) in the cavity all around said microcircuit.

11. Method according to Claim 9, wherein said cavity is defined which further includes a margin (39) having a height corresponding to the thickness of said board, **characterised in that** said peripheral margin is treated to improve subsequent gluing of said board to said peripheral margin area.

12. Method according to Claim 7, **characterised in that** fixing said board entails heating a heat-activated adhesive deposited onto said annular area.

13. Method according to Claim 7, **characterised in that** the treatment of said annular area includes the formation of microcavities or microgrooves (48) therein and **in that** fixing said board consists in heating said annular area when in place on said other plane support to cause the material thereof to flow into said microcavities or microgrooves.
